# EUROPEAN PATENT APPLICATION

(11) **EP 0 770 700 A1**
(43) Date of publication of application: **02.05.1997**
(21) Application number: 96117151.9
(22) Date of filing: 25.10.1996
(51) Int. Cl.: C23C 14/28, C23C 14/08, H01L 39/24

(54) **Process for formation of oxide thin film**

(30) Priority: 26.10.1995 JP 300455/95
(71) Applicant: INTERNATIONAL SUPERCONDUCTIVITY TECHNOLOGY CENTER, Minato-ku, Tokyo (JP); E.I. DU PONT DE NEMOURS AND COMPANY, Wilmington Delaware 19898 (US)
(72) Inventor: Rai, Bunichi, Tokyo (JP); Enomoto, Youichi, Tokyo 179 (JP)
(74) Representative: Kraus, Walter, Dr.

(57) **Abstract**

A process for formation of oxide thin film, which comprises applying a laser beam on a target oxide material to generate a vapor therefrom and depositing the vapor on a substrate to form an oxide thin film on the substrate, wherein the formation of an oxide thin film on the substrate is conducted by disposing the target and the substrate face to face, scanning the laser beam applied onto the target, in a direction normal to the target central axis, and rotating the substrate.

## Description

### Field of the Invention

The present invention relates to a process for formation of oxide thin film, which comprises applying a laser beam onto a target oxide material to generate a vapor therefrom and depositing the vapor on a substrate to form an oxide thin film on the substrate.

### Background and Prior Art of the Invention

Since the invention of high-Tc oxide super-conductive material, many studies on process for formation of oxide thin film have been made and significant progress has been seen in the process. Of various such processes so far developed, a process is in wide use which comprises applying a laser beam onto an oxide bulk to generate an oxide vapor and depositing the oxide vapor on a substrate to form an oxide thin film on the substrate. In this conventional process, however, the portion of the oxide thin film, containing a small amount of particles and having a clean surface, is very small, and it was difficult to obtain an oxide thin film of large area containing a small amount of particles and having a clean surface. The particles refer to a mass of particles which are produced on a substrate by non-epitaxial growth when a target (e.g. a ceramic) is excited at a high temperature by a laser beam and the activated and gasified molecules of the target are deposited on the substrate. The particles makes the surface of the oxide thin film nonuniform and this is a problem particularly in patterning of electronic devices.

The object of the present invention is to provide a process for formation of oxide thin film, which can form, on a substrate, a high-quality oxide thin film containing a small amount of particles, stably and in a large area.

### Summary of the Invention

The present invention provides a process for formation of oxide thin film, which comprises applying a laser beam on a target oxide material to generate a vapor therefrom and depositing the vapor on a substrate to form an oxide thin film on the substrate, wherein the formation of an oxide thin film on the substrate is conducted by disposing the target and the substrate face to face, scanning the laser beam applied onto the target, in a direction normal to the target central axis, and rotating the substrate.

In a process for formation of oxide thin film, which comprises applying a laser beam onto a target oxide material to generate a vapor therefrom and depositing the vapor on a substrate to form an oxide thin film on the substrate, particles are formed only in a small amount in the center and its vicinity of a gaseous flame (i.e. plume) generated by the vaporization of the laser beam-irradiated target, but the amount of particles is larger in the portion of the plume more distant from the center (the amount is the largest at the periphery of the plume).

In the present invention, the plume is moved by disposing the target and the substrate face to face, rotating a mirror (this has hitherto been fixed) to scan the laser beam applied onto the target, in a direction normal to the target central axis, and rotating the substrate; thereby, an oxide thin film containing a small amount of particles is formed on the substrate utilizing only the center and its vicinity of the plume. It is simply anticipated that when the plume is moved, not only the center and its vicinity of the plume but also the periphery of the plume containing a large amount of particles contribute to the formation of an oxide thin film on the substrate, resulting in the formation of an oxide thin film containing a large amount of particles. Contrary to the anticipation, however, it became clear in the present invention that the movement of the plume center removed the bad influence of the plume periphery and only the plume center contributed to the formation of an oxide thin film on the substrate. Also in the present invention, the movement of the plume enabled reduction in the amount of in-plume particles.

### Brief Description of the Drawings

Fig. 1 is a schematic drawing of an apparatus for formation of thin film, suitable for carrying out the process for formation of oxide thin film according to the present invention.

Fig. 2 is schematic drawings each showing a mode in which a thin film is deposited on a substrate when laser beam scanning is conducted or is not conducted and substrate rotation is conducted or is not conducted.

### Description of the Example Embodiment

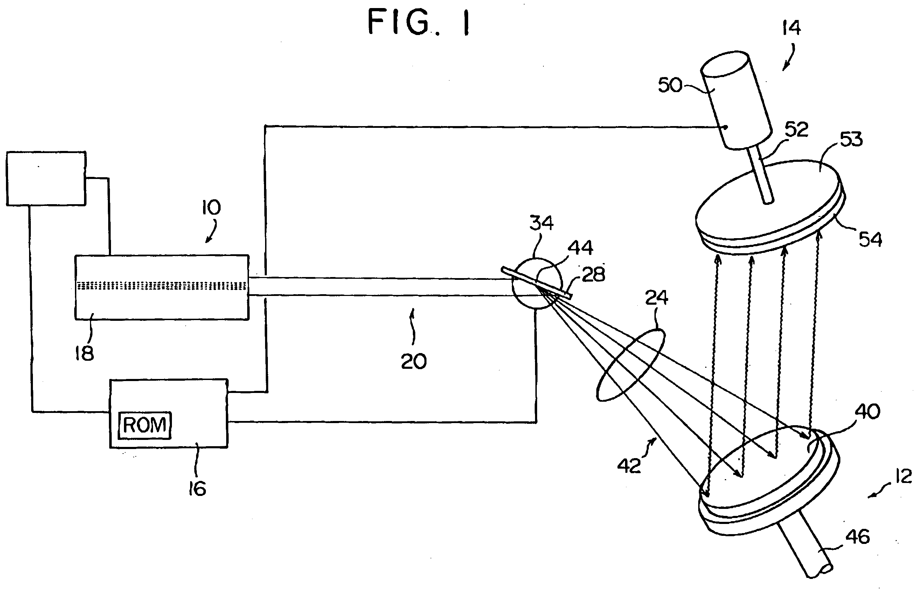

The apparatus for formation of thin film, shown in Fig. 1 comprises a laser beam applicator 10, a target holder 12, a substrate holder 14 and a controller 16.

The laser beam applicator 10 comprises a laser beam source 18 and an optical system 20. The laser beam source 18 emits a Kr-F excimer laser beam (λ = 248 nm) at 5 Hz in a pulsed state in accordance with the output of a pulse-controlling means 19. The optical system 20 comprises a lens 24, a mirror 28 and a scanner 34 for partial rotation of mirror 28.

The laser beam emitted from the laser beam source 18 is reflected on the mirror 28, is condensed by the lens 24, and is applied onto a target 40 supported on the target holder 12.

The scanner 34 for mirror-partial rotation gives rise to stepwise partial rotation of the mirror 28 about a rotation shaft 44, whereby a laser beam 42 is scanned as mentioned below. As a result, the laser beam 42 is moved on the target 40 and is scanned in a direction normal to the central axis of the target 40 extending in the same direction as the rotation shaft 46 of the target holder 12.

The target holder 12 supports the target 40 made of, for example, a YBa₂Cu₃O_{7-δ} ceramic. Similarly in the conventional apparatus for thin film formation, it is preferable that the target holder 12 is connected to a device (not shown in Fig. 1) for rotating the target holder 12 and that the target 40 is rotated about the rotation shaft 46 of the target holder at a predetermined rotational speed. With the rotation of the target 40 alone, such as conducted in the conventional apparatus, a groove of circular ring shape is formed on the target surface by the application of a laser beam and, therefore, the target surface must be ground at certain time intervals. In contrast, in the present invention, the laser beam is scanned on the target 40; this scanning plus the rotation of the target 40 bring about the uniform grinding of target surface by laser beam and makes unnecessary the grinding of target surface at certain time intervals which has been necessary heretofore.

The substrate holder 14 comprises a device 50 for substrate rotation, a rotation shaft 52 of the device 50 and a rotating plate 53 connected to the rotation shaft 52; supports a substrate 54 on the rotating plate 53; and rotates the substrate at a speed of, for example, 1-5 rpm, preferably 2-3 rpm.

The target 40 and the substrate 54 are disposed face to face by providing them, for example, in such a manner that (1) the central axis of the target 40 extending in the direction of the rotation shaft 46 of the target holder 12 and (2) the central axis of the substrate 54 extending in the direction of the rotation shaft 52 of the device 50 for substrate rotation, intersect each other.

The controller 16 controls the operation of the scanner 34 for partial rotation of mirror, the device 50 for substrate rotation, etc. in accordance with the data stored in the ROM.

The target 40, the rotation shaft 46, the target holder 12, the substrate 54; the rotating plate 53 and the device 50 for substrate rotation are placed in a chamber not shown in Fig. 1. The chamber has a quartz glass window not shown in Fig. 1. The laser beam 42 from the mirror 28 passes through the lens 24; enters the chamber via the quartz glass window; and is applied onto the target 40. A desired atmosphere is used in the chamber. The atmosphere used is determined depending upon the the properties of the thin film formed on the substrate. It is known that when the thin film formed is a superconductive oxide thin film, the presence of oxygen in the atmosphere is necessary.

The intensity of the laser beam required varies depending upon the incidence angle of the laser beam on the target 40. Too small an incidence angle is not preferred because there arises a difference in laser beam intensity between one end of the beam-applied area of the target 40 and the other end and the amount of the target material vaporized differs between the two ends. In order to make small the change in incidence angle in beam-applied area, it is effective to make large the distance between the laser beam applicator 10 (in particular, the mirror 10 in Fig. 1) and the target 40. This distance, however, is restricted by the size of the chamber; therefore, the distance between the mirror 28 and the target 40 is determined so that the incidence angle of the laser beam 42 on the target 40 in the beam-applied area is in the range of, for example, 40-60". By appropriately operating the optical system 20 by, for example, making the incidence angle of laser beam on target in beam-applied area, as constant as possible, the intensity of laser beam applied on target 40 can be made as constant as possible.

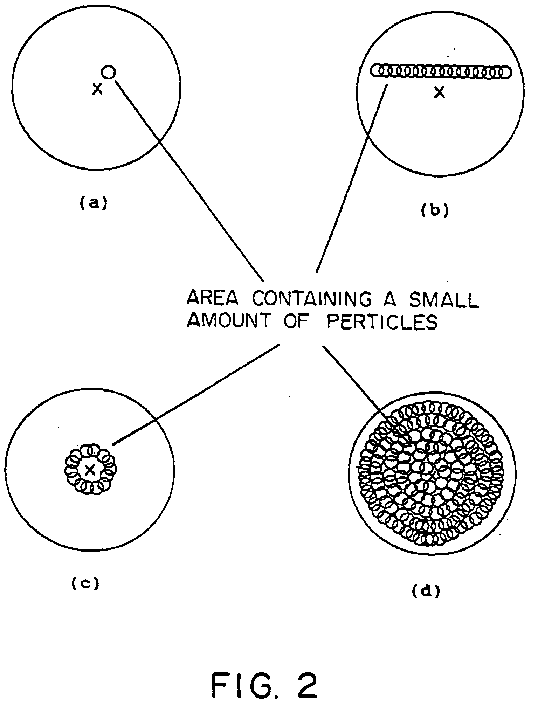

In Fig. 2 are shown schematic drawings each of a thin film formed on a substrate surface when the laser beam applied is scanned or is not scanned and the substrate is rotated or is not rotated. The center of a plume, which consists of an area surrounded by a circle (o) and containing a small amount of particles and which contributes to thin film formation, moves on a substrate 54 along a straight line distant from the center (X) of the substrate 54 by about 10 mm [Fig. 2(b)]. In this case, when the substrate 54 is rotated, the plume moves on the substrate 54 two-dimensionally [Fig. 2(d)]. A more uniform thin film can be formed when the plume moves on the target 54 along a straight line slightly apart from the substrate center, as compared to when the plume moves along a straight line passing the substrate center.

The laser beam 42 is moved on the target 40 in a scanning width of 10-70 mm at 30-150 cycles per minute. When the width of the target area in which the target 40 is irradiated with the laser beam 42, i.e. the scanning width is larger, a better result is obtained, but the scanning width must be slightly smaller than the diameter of the target. For example, when the target has a circular shape of 20 mm in diameter, the scanning width is preferably 16-18 mm. Thus, the laser beam 42 moves on the target 40 in a straight line at a constant speed over the scanning width (e.g. 16-18 mm), returns to the original position, and repeats the reciprocal straight-line movement 30-150 times per minute.

The apparatus for formation of thin film, shown in Fig. 1 is operated as follows.

First, the chamber inside is filled with a predetermined atmosphere. The device 50 for substrate rotation is started and the substrate 54 supported on the substrate holder 14 is rotated at a constant speed of, for example, 3 rpm. Then, the laser beam applicator 10 is started to emit a laser beam from the laser beam source 18; and the mirror 28 is rotated by the scanner 34 for partial rotation of mirror, by a given angle continuously in one direction to scan the laser beam 42, and returns to the original position. Thus, the laser beam 42 is moved on the target 40 continuously, for example, at a scanning width of 18 mm and 55 cycles per minute. The laser beam 42 is moved on the target 40 linearly by the scanning width which is about equal to the substrate width, and returns to the original position. This movement is repeated for 30 minutes, for example, and the laser beam application is completed.

Fig. 2 is schematic drawings each showing a mode in which a thin film is deposited on a substrate when laser beam scanning is conducted or is not conducted and substrate rotation is conducted or is not conducted.

Fig. 2(a) to Fig. 2(d) each shows a condition of the substrate 54 seen from under. In Fig. 2, X refers to the center of substrate rotation and o refers to a deposited area containing a small amount of particles. This deposited area containing a small amount of particles is a position of the substrate 54 corresponding to the laser beam-applied position of the target 40, because the target 40 and the substrate 54 are disposed face to face.

Fig. 2(a) is a case according to the conventional process for thin film formation, i.e. a case where neither laser beam scanning nor substrate rotation is conducted. In this case, one position on the substrate corresponding to the laser-beam-applied position of the target becomes a deposited area containing a small amount of particles.

Fig. 2(b) is a case where laser beam scanning is conducted as in the present invention process but no substrate rotation is conducted. In this case, the belt-shaped area on the substrate corresponding to the laser-beam-applied portion of the target becomes a deposited area containing a small amount of particles.

Fig. 2(c) is a case where no laser beam scanning is conducted unlike in the present invention process but substrate rotation is conducted. In this case, the circular ring-shaped area on the substrate corresponding to the laser-beam-applied portion of the target becomes a deposited area containing small amount of particles.

In any of Fig. 2(a) to Fig. 2(c), only part of the substrate becomes a deposited area containing a small amount of particles.

Fig. 2(d) is a case according to the present invention process, i.e. a case where both laser beam scanning and substrate rotation are conducted. In this case, almost all the portions on the substrate become a deposited area containing a small amount of particles.

According to the present process, by combining laser beam scanning and substrate rotation, a deposited area containing a small amount of particles can be made large significantly.

### Example 1

The optical axis of a laser beam was rotated by the use of a mirror, whereby the laser beam was scanned on a circular target having a diameter of 22 mm, at a scanning width of 18 mm 55 times per minute. A LaAlO₃ substrate having a diameter of 50 mm was rotated at 3 rpm. The target was a ceramic made of YBa₂Cu₃O_{7-δ}. The laser beam was a Kr-F excimer leaser beam (λ = 248 nm) and applied on the target at 5 Hz in an amount of 0.1 J/cm². Thin film formation was conducted for 30 minutes at a substrate temperature of 700°C at an oxygen partial pressure of 100 mTorr.

The number of particles of 1 µm or more in diameter, deposited on the substrate of 50 mm in diameter was 1.02 x 10³/mm² and could be reduced to about 1/5 of the number (5.08 x 10³/mm²) when neither laser beam scanning nor substrate rotation was conducted. The results of the numbers of particles are shown in Table 1. Each number of particles was obtained by taking a microscopic photograph of the surface of a formed thin film, counting the number of particles in the area of 70 µ x 50 µ at each of the five points on the surface, i.e. the center of the thin film, a point 7 mm distant from the center, a point 14 mm distant from the center, a point 20 mm distant from the center and a point 24 mm distant from the center, and calculating the average of the five numbers.

**Table 1**

| | | Number of particles | |
|---|---|---|---|
| | | No laser scanning | Laser scanning |
| Substrate rotation | No | 5.08 x 10³/mm² | 2.51 x 10³/mm² |
| | Yes | 4.85 x 10³/mm² | 1.03 x 10³/mm² |

### Example 2

The optical axis of a laser beam was rotated by the use of a mirror, whereby the laser beam was scanned on a circular target having a diameter of 22 mm, at a scanning width of 18 mm 55 times per minute. A MgO substrate having a square shape of 20 mm x 20 mm was rotated at 2.5 rpm. The target was a ceramic made of YBa₂Cu₃O_{7-δ}. The laser beam was a Kr-F excimer leaser beam (λ = 248 nm) and applied on the target at 5 Hz in an amount of 0.1 J/cm² Thin film formation was conducted for 30 minutes at a substrate temperature of 700°C at an oxygen partial pressure of 100 mTorr.

The number of particles of 1 µ or more in diameter, deposited on the square MgO substrate of 20 mm x 20 mm was 5.1 x 10²/mm² and could be reduced to about 1/30 of the number (164 x 10²/mm²) when neither laser beam scanning nor substrate rotation was conducted. The numbers of particles of 1 µ or more are shown in Table 2.

**Table 2**

| | | Number of particles | |
|---|---|---|---|
| | | No laser scanning | Laser scanning |
| Substrate rotation | No | 164 x 10²/mm² | 98 x 10²/mm² |
| | Yes | 107 x 10²/mm² | 5.1 x 10²/mm² |

As seen from Table 1 and Table 2, when there is laser beam scanning (but there is no substrate rotation), as compared with when there is no laser beam scanning (there is no substrate rotation, either), the number of particles is about 1/2. That is, by changing the position of particle generation on target and widening the position of plume formation, a plume containing a small amount of particles can be obtained reliably. Therefore, by moving this plume containing a small amount of particles, on the substrate in a direction normal to the central axis of the substrate and also by rotating the substrate, a desired effect can be obtained.

As is clear from the results of Table 1 and Table 2, when there are laser beam scanning and substrate rotation, the number of particles is greatly reduced by the synergistic effect of the two parameters, and the plume center and its vicinity (both containing a small amount of particles) make main contribution to the formation of oxide thin film. Thus, when there are laser beam scanning and substrate rotation, the periphery of plume containing a large amount of particles shows no bad influence and laser beam scanning gives no adverse effect.

As stated above, by combining laser beam scanning and substrate rotation according to the present invention, it becomes possible to make large the deposited area containing a small amount of particles, formed on a substrate and consequently form, on the substrate, a clean thin film containing a small amount of particles, by pulsed laser deposition. This enables finer patterning and production of increased number in production of electronic devices.

## Claims

1. A process for formation of oxide thin film, which comprises applying a laser beam on a target oxide material to generate a vapor therefrom and depositing the vapor on a substrate to form an oxide thin film on the substrate, wherein the formation of an oxide thin film on the substrate is conducted by disposing the target and the substrate face to face, scanning the laser beam applied onto the target, in a direction normal to the target central axis, and rotating the substrate.

2. A process according to Claim 1, wherein the target is rotated about the central axis.

3. A process according to Claim 1 or 2, wherein the target and the substrate are disposed so that the plume, which is a gaseous flame generated by the vaporization of the laser beam-irradiated target, can move on a straight line on the substrate, not passing the substrate center.
